# EUROPEAN PATENT SPECIFICATION

(11) **EP 0 595 976 B1**
(45) Date of publication and mention of the grant of the patent: **04.03.1998**
(21) Application number: 92916347.5
(22) Date of filing: 24.07.1992
(51) Int. Cl.: H04B 1/30, H03D 1/22

(54) **AM RECEIVER**
AM Empfänger
RECEPTEUR A MODULATION D'AMPLITUDE

(30) Priority: 24.07.1991 GB 91160515
(43) Date of publication of application: 11.05.1994
(73) Proprietor: PHASE TRACK LTD., Elgar Road, Reading RG2 0AU (GB)
(72) Inventor: FORSTER, Edward Charles, Reading, Berkshire RG6 2DN (GB)
(74) Representative: Burke, Steven David
(86) International application number: GB9201376
(87) International publication number: WO9302507

(56) References cited:
- EP-A- 0 401 771
- GB-A- 2 029 139
- GB-A- 2 099 245
- GB-A- 2 152 311
- Wireless World, September 1981, pages 79-81, 83 D.A.Tong: Phase locked detector for double-sideband, diminished carrier reception

## Description

This invention relates to AM receivers, and is particularly but not exclusively applicable to AM broadcast receivers suitable for receiving long, medium and short wave range broadcasts.

Direct-conversion receivers, in which the received RF signal is directly demodulated to produce an audio signal without the use of IF stages, have been known. Direct-conversion receivers are desirable because of their simplified construction and improved performance. Unwanted image responses can be avoided and the setting of the bandwidth can be carried out more accurately and cheaply than with conventional IF filters. However, high quality reception requires accurate synchronous detection, and the use of a phase-locked loop which accurately reconstitutes and maintains the carrier frequency. Thus, it has not so far been possible to provide a direct-conversion receiver of high quality, using synchronous demodulation at a competitive price.

GB-A-2 099 245 discloses an AM receiver having a phase-locked loop, formed by a Costas loop, in which there is provided oscillating means for synchronously demodulating an input signal to produce in-phase and phase-quadrature output signals, and means for mixing the output signals to produce the error signal of the phase-locked loop. However, when the modulated RF signal is not present, or there is an overriding amount of noise, the error signal necessary to maintain the local oscillator at its locked position is lost. When the RF signal reappears, the loop will take a finite time to synchronise.

"Wireless World, September 1981, pages 79-81, 83 D.A. Tong : Phase locked detector for double-sideband, diminished carrier reception." discloses a phase-locked detector for double-side-band, diminished-carrier reception. The phase-locked loop is said to track the low level carrier even in the absence of speech. This is achieved by using a phase-locked loop responsive to the low-level carrier for tracking the carrier frequency in order to allow synchronous demodulation. An integrated circuit is used in the phase-locked loop to act as a low-pass filter and provide a small bandwidth so that even very low carrier levels can be reliably filtered from the received noise.

According to the present invention there is provided an AM receiver having a phase-locked loop including oscillating means for synchronously demodulating an input signal to produce in-phase and phase-quadrature output signals, and means for mixing the output signals to produce the error signal of the phase-locked loop, characterised by an integrating circuit in the phase-locked loop responsive to the error signal for controlling the oscillator means of the loop so as to maintain synchronisation during modulation pauses.

It is envisaged that the input signal would be an RF signal and that the receiver would be a direct-conversion receiver. Synchronisation is established and maintained accurately using a very simple circuit employing the techniques of the present invention. This involves the use of the known Costas loop, in which the in-phase and phase-quadrature demodulated signals are mixed to produce a voltage proportional to the phase of the carrier (even when the carrier is not present in the input signal). This alone would not in practice provide effective maintenance of synchronisation to received analog AM broadcasts. However, the use of the integrating circuit will ensure that momentary lapses of modulation are accommodated without loosing synchronisation, because the circuit will maintain the control voltage applied to the oscillator means.

The receiver of the preferred embodiment is suitable for use with double sideband signals transmitted either with or without a carrier. In the case of signals transmitted with a carrier, it is possible for the carrier to interfere with the operation of the phase-locked loop before the loop locks on to the correct frequency. Variations in modulation levels are in practice found to be substantial, and this can also interfere with the loop operation. Various preferred aspects of the invention are intended to deal with these difficulties.

In the preferred embodiment, automatic gain control circuits are provided to maintain the levels of the in-phase and phase-quadrature signals so that the overall loop gain is correct irrespective of changes in modulation levels. Also, filters are preferably provided to remove from the in-phase and phase-quadrature signals any components resulting from the presence of the carrier. The automatic gain control circuit is preferably designed so that it also is relatively insensitive to these components compared with the sensitivity to the modulation components.

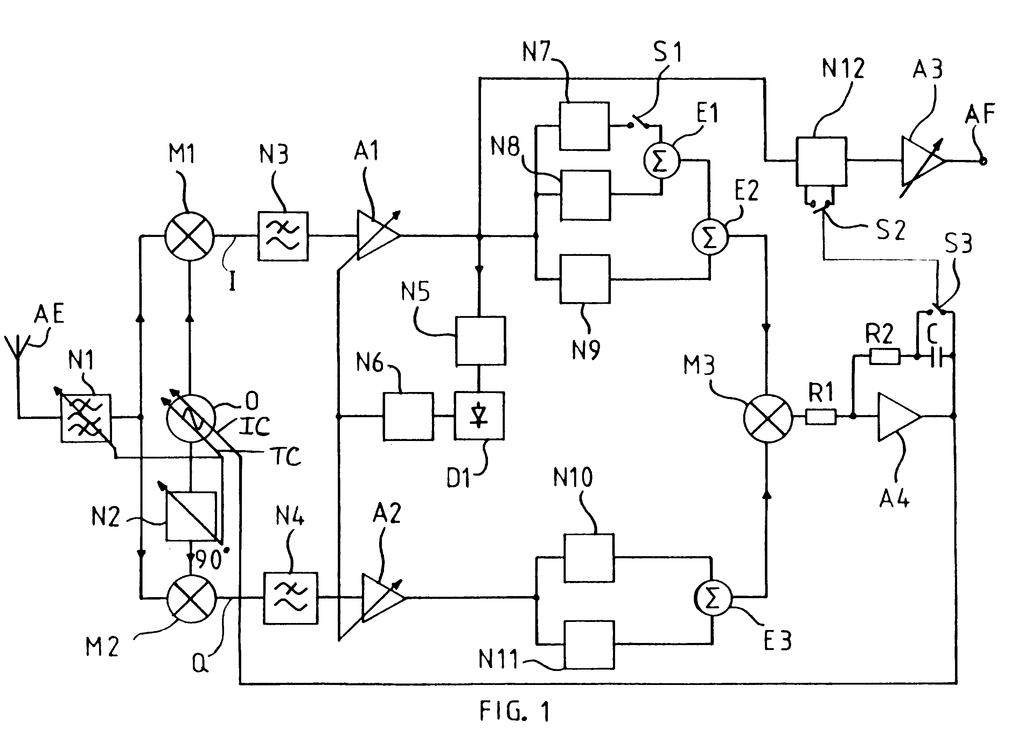

An arrangement embodying the present invention will be described with reference to the accompanying drawings, of which the single figure, Figure 1, shows a block diagram of an AM receiver in accordance with the invention.

The signal from an antenna AE passes through a band pass filter (or possibly a low pass filter) N1 and then is applied to two mixers M1 and M2. An oscillator O operating at the incoming carrier frequency is applied to M1 and also, after passing through a 90° phase shifter N2, to mixer M2.

At synchronism, the output I of the mixer M1 comprises an in-phase output, and the output Q of mixer M2 comprises a phase-quadrature output. These outputs are filtered by low-pass networks N3 and N4, which are set to pass the baseband frequencies of the channel being received and delivered via circuitry N5 to N11, D1, A1, A2, E1 to E3 to be described below to a mixer M3, which is a linear multiplier and which produces an output voltage proportional to the phase of the carrier.

This output voltage is supplied to the remainder of the feedback loop comprising amplifier A4, resistors R1 and R2, capacitor C and oscillator 0. The amplifier A4 and the associated components R1 and C provide a virtually perfect integrator if adjusted correctly. The output comprises a control voltage which is applied to an incremental control terminal IC of the oscillator O to adjust the frequency of the oscillator. This frequency modulation is small, and nearly constant throughout the receiver's frequency range so that the loop gain remains substantially constant.

The feedback loop is therefore a Type II loop, where this refers to the number of integrators in the loop. The integrating circuit A4, R1 and C forms one of these integrators, and the voltage controlled oscillator O also performs an integrating function as is known.

In operation, the error signal generated by mixer M3 is driven to zero by the loop action when the loop is synchronised. Momentary lapses of modulation can be accommodated since the loop control voltage is held by the voltage across capacitor C. Thus, the circuit remains substantially synchronised at all times.

The receiver output AF is derived from the in-phase signal I via a switchable attenuator N12 and an amplifier A3 having a manually variable gain.

Usually in AM transmissions, the carrier is present and is on average 10 dB higher than the modulation. If the synchronisation is disturbed, the presence of the carrier will result in the in-phase signal I and the phase-quadrature signal Q including a high amplitude, low frequency component resulting from the presence of the carrier. This can interfere with the operation of the mixer M3. In order to avoid this, high pass filters N9 and N11, preferably of identical characteristics, are included in the signal paths for the in-phase and phase-quadrature signals I and Q.

The demodulated signal which appears as the in-phase signal I will have a level that tends to vary, for example as a result of changing modulation levels. This would affect the loop gain of the phase-locked loop. To maintain the loop gain at the appropriate level, an automatic gain control is provided. This is formed by feedback control networks N5 and N6 together with a diode D1, which can control the gain of amplifiers Al and A2 which are respectively in the in-phase signal I path and the phase-quadrature signal Q path. It is important to prevent incorrect operation of the automatic gain control as a result of the presence of signal components resulting from the carrier when the phase-locked loop is not fully synchronised. Accordingly, network N5 and diode D1 (which is preferably a full wave type) act as a charge pump system having a lower sensitivity at low frequencies compared to high frequencies, so that the low frequency components resulting from the carrier when the oscillator is slightly out of synchronism do not excessively influence the operation of the automatic gain control. The network N6 determines the attack and decay of the automatic gain control loop.

The operation of the phase-locked loop is controlled by the error signal generated by mixer M3, and this is dependent on both the difference between the frequency of the oscillator O and the carrier frequency, and on the level of the demodulated signal. It will therefore be appreciated that the presence of an automatic gain control which affects the demodulated signal level could interfere with the correct operation of the phase-locked loop. The automatic gain control is therefore carefully designed to avoid this. In practice, the loop bandwidth of the phase-locked loop will be less than 1000 Hertz, and preferably less than 100 Hertz. The loop bandwidth of the automatic gain control is preferably substantially less than that of the phase-locked loop. If the receiver output AF is derived from the output of the amplifier Al, a low loop bandwidth for the automatic gain control is also desirable to avoid perceptible interference with the output signal levels.

Initial tuning is accomplished by adjustment of the oscillating frequency of the oscillator O using a main tuning control TC. Preferably, this is ganged to controls of the filter N1 and the phase shifter N2, so that these track adjustments in the tuning frequency. The purpose of the filter N1 is to eliminate the only significant spurious response, which is the third harmonic of the local oscillator. The tuning control TC may also be used for tuning the antenna, which may be constituted by a small rod antenna, thus giving better performance than untuned active antenna counterparts. If a tunable antenna is used, the filter N1 may be omitted.

A number of features are provided to facilitate the initial synchronisation and maintenance of synchronisation during path disturbances, which otherwise could be a problem particularly with shortwave reception.

One aspect involves the use of a frequency discriminating arrangement which affects low frequency signals in the phase-quadrature signal path in a different manner from the low-frequency signals in the in-phase signal path. High frequencies are treated correspondingly in both paths. When the phase-locked loop is out of synchronisation, as indicated above, low frequency components of the carrier signal are present in the in-phase signal I and phase-quadrature signal Q paths. Because of the 90° phase difference, if these signals were applied directly to the mixer M3 there would be a substantially zero error signal output by the mixer M3, and therefore the phase-locked loop would not move towards synchronisation. The frequency discriminator however applies the carrier components to the mixer M3 but alters the phase relationship between them so that an error signal is generated which is sufficient to allow the phase-locked loop to lock in on the carrier. As the oscillation frequency approaches that of the carrier, the error signal resulting from the carrier components will start to disappear, but by this time the modulation components will start to generate an error signal to complete the synchronisation.

In the present embodiment, the frequency discriminator is formed by networks N8 and N10. N10 is a high pass filter which passes modulation frequencies without substantially affecting the phase thereof. Lower frequencies, such as those resulting from the carrier components, will have their phases affected. Network N8 may consist of a simple attenuator which provides a similar degree of attenuation to that of the network N10. The gains of the frequency discriminating components N8 and N10 are set for the correct loop operation during modulation control. To increase the pull-in speed and/or range of the loop, a further network N7 may be provided, this being momentarily coupled in circuit by closure of the switch S1 at the commencement of tuning, which has the effect of temporarily reducing the attenuation in the in-phase signal path.

Accordingly, even though the phase-locked loop incorporate filters N9 and N11 to remove the effects of the carrier when the loop is close to synchronisation, it has further components N7, N8 and N10 which utilise the carrier to initiate lock-in of the loop.

Summing circuit El sums the outputs of networks N7 and N8, summing circuit E2 sums the output of sum El and network N9, and summing E3 sums the outputs of networks N10 and N11, as shown in Figure 1, the outputs of the summers of E2 and E3 forming the inputs to mixer M3.

A switch S3 is provided for temporarily short circuiting the integrating capacitor C to reset the integrating circuit until the lock-in range of the phase-locked loop is reached. During this period, it is preferable also to switch the attenuator N12 into operation using the switch S2 so as to reduce the output volume until synchronisation is achieved.

The networks N1 to N12 may all be passive networks. In practice, the circuits N1, N2 and O can be tuned by a ganged variable capacitor. The filter N1 is preferably double tuned, and N2 can be simply constructed using a low Q series inductance tuned by a shunt capacitor formed by one of the ganged sections. N3 and N4 can be simply made with inductors and capacitors. Networks N5 to N11 may be simple resistor/capacitor networks. All mixers are preferably double balanced.

The receiver of the present invention, because it operates synchronously, exhibits very little nonlinear distortion compared to conventional receivers using envelope detectors. Because synchronisation is dependent on the sideband modulation, it is possible to recover the carrier with the best phase for demodulating the signal, compared with conventional synchronous receivers which rely on the carrier alone. Since no synthesiser is used, the spectral purity of the oscillator is very good and power consumption is very low.

The frequency setting can easily be obtained by reading the frequency of the oscillator O.

Although the described circuit is preferably used as a direct-conversion receiver, it would alternatively be possible for it to be used as an intermediate frequency stage of a receiver. In this case, the intermediate frequency signal could be presented to the illustrated circuit in place of the RF signal. Alternatively, the mixers M1 and M2 may be driven by a fixed-frequency oscillator, the variable oscillator O instead forming the reference input to a mixer which generates the intermediate frequency fed to the mixers M1 and M2, so that the oscillator controls the input frequencies of these mixers rather than the reference frequencies.

Integrating circuit A4, R1 and C may be formed by any circuit which electronically or mechanically simulates an integrating function. Although the preferred arrangement is as illustrated an active analog filter, it would alternatively be possible to use sample and hold techniques for performing a sampled integration. In any event, the phase-locked loop should be a Type II loop, wherein there is a zero level error signal when the loop is locked-in.

The automatic gain control may be arranged to respond to a combination of the in-phase and phase-quadrature signals I and Q (for example by adjusting gain in response to the signal of largest amplitude). The Q signal may provide more effective control when the loop is out of synchronisation.

It is not essential to have a tracking phase shifter N2. It would be possible, for example, for the voltage controlled oscillator to operate at four times the carrier frequency, and use appropriate frequency dividing circuits to generate the in-phase and phase-quadrature reference signals.

If desired, the described oscillator could be replaced by a frequency synthesiser adjustable in frequency by the integrating circuit.

If a frequency synthesiser or some other frequency selecting means is used, an automatic method of synchronisation is preferably employed. This could be achieved by entering a fast acquisition mode until detection of a condition in which a signal is present on the in-phase signal I path, but substantially no signal is present on the phase-quadrature signal Q path, which is the condition when lock is achieved. The fast acquisition mode can be obtained by for example speeding up and/or increasing the pull-in range of the frequency discriminator and or increasing the loop bandwidth. Loop bandwidth can be increased by increasing the loop gain and/or changing the R1, R2, C values.

Simple logic can be used to sequence these events as well as resetting the integrator between frequency changes and muting the audio output until the receiver has locked in.

If desired, cancellation of one of the sidebands could be achieved, for example by phase-shifting the phase-quadrature signal Q by 90° and then adding this to the in-phase signal I, or subtracting one from the other, to obtain a demodulated upper or lower sideband.

Although the receiver is designed for use with AM broadcasts which include the two sidebands, with or without the carrier, it has been observed that close synchronisation is nevertheless achieved with signals including a single sideband and the carrier.

## Claims

1. An AM receiver having a phase-locked loop (O,M3,A4,R₁,R₂) including oscillating means (O) for synchronously demodulating an input signal to produce in-phase (I) and phase-quadrature (Q) output signals, and means (M3) for mixing the output signals to produce the error signal of the phase-locked loop, characterised by an integrating circuit (A4,R₁,R₂) in the phase-locked loop responsive to the error signal for controlling the oscillating means (O) of the loop so as to maintain synchronisation during modulation pauses.

2. A receiver as claimed in claim 1, wherein the input signal is an RF signal and the receiver is a direct-conversion receiver.

3. A receiver as claimed in claim 1 or claim 2, having high-pass filter means (N9,N11) for removing from the in-phase and phase-quadrature output signals components resulting from the presence of the carrier when the phase-locked loop is close to synchronisation.

4. A receiver as claimed in any preceding claim, including means (N8,N10) for varying the phase of low-frequency components in the phase-quadrature output signal relative to low-frequency components in the in-phase output signal so as to cause an error signal to be produced in response to carrier components of the in-phase and phase-quadrature output signals while the loop is out of synchronisation to facilitate locking-in of the loop.

5. A receiver as claimed in claim 4, wherein the phase-varying means (N8,N10) is arranged so that the phases of signals having baseband frequencies are substantially unaffected.

6. A receiver as claimed in any preceding claim, including automatic gain control means (A1,A2) in the paths of the in-phase and phase-quadrature output signals.

7. A receiver as claimed in claim 6, wherein the automatic gain control means comprises a variable gain amplifier (A1,A2) in each of said paths, both of the amplifiers being controlled in response to the level of the in-phase output signal (I).

8. A receiver as claimed in claim 6 or claim 7, wherein the loop bandwidth of the automatic gain control means (A1,A2) is substantially less than that of the phase-locked loop (O,M3,A4,R₁,R₂).

9. A receiver as claimed in any one of claims 6 to 8, wherein the automatic gain control means (A1,A2) is relatively insensitive to low frequencies so that it is substantially unaffected by the presence of components resulting from the presence of a carrier prior to synchronisation of the loop.

## Patentansprüche

1. AM-Empfänger mit einer phasenstarren Schleife (O, M3, A4, R₁, R₂), die eine Oszillatoreinrichtung (O) zum synchronen Demodulieren eines Eingangssignals unter Erzeugung eines gleichphasigen Ausgangssignals (I) und eines um 90° phasenverschobenen Signals (Q) sowie eine Einrichtung (M3) zum Mischen der Ausgangssignale unter Erzeugung des Fehlersignals der phasenstarren Schleife aufweist, gekennzeichnet durch eine in der phasenstarren Schleife enthaltene Integrierstufe (A4, R₁, R₂), die die Oszillatoreinrichtung (O) der Schleife in Abhängigkeit von dem Fehlersignal so steuert, daß die Synchronisation während Modulationspausen aufrechterhalten wird.

2. Empfänger nach Anspruch 1, wobei das Eingangssignal ein Radiofrequenzsignal und der Empfänger ein solcher mit Direktumwandlung ist.

3. Empfänger nach Anspruch 1 oder 2 mit einer Hochpaß-Filtereinrichtung (N9, N11), die aus dem gleichphasigen und dem um phasenverschobenen Ausgangssignal Komponenten entfernt, die aus dem Vorhandensein des Trägers resultieren, wenn die phasenstarre Schleife nahezu synchronisiert ist.

4. Empfänger nach einem der vorhergehenden Ansprüche mit einer Einrichtung (N8, N10) zum Ändern der Phase niederfrequenter Komponenten in dem phasenverschobenen Ausgangssignal relativ zu niederfrequenten Komponenten in dem gleichphasigen Ausgangssignal, damit, solange die Schleife außer Synchronisation ist, ein Fehlersignal entsprechend den Trägerkomponenten des gleichphasigen und des phasenverschobenen Ausgangssignals erzeugt und dadurch die Synchronisation der Schleife erleichtert wird.

5. Empfänger nach Anspruch 4, wobei die Phasenänderungseinrichtung (N8, N10) so ausgelegt ist, daß die Phasen von Signalen mit Frequenzen im Grundband im wesentlichen nicht beeinflußt werden.

6. Empfänger nach einem der vorhergehenden Ansprüche mit einer automatischen Verstärkungssteuereinrichtung (A1, A2) in den Pfaden des gleichphasigen und des phasenverschobenen Ausgangssignals.

7. Empfänger nach Anspruch 6, wobei die automatische Verstärkungssteuereinrichtung in jedem der Pfade einen Verstärker (A1, A2) mit variabler Verstärkung aufweist und beide Verstärker in Abhängigkeit vom Pegel des gleichphasigen Ausgangssignals (I) gesteuert sind.

8. Verstärker nach Anspruch 6 oder 7, wobei die Schleifenbandbreite der automatischen Verstärkungssteuereinrichtung (A1, A2) wesentlich geringer ist als die der phasenstarren Schleife (O, M3, A4, R₁, R₂).

9. Verstärker nach einem der Ansprüche 6 bis 8, wobei die automatische Verstärkungssteuereinrichtung (A1, A2) für niedrige Frequenzen verhältnismäßig unempfindlich ist, so daß sie durch das Vorhandensein von Komponenten, die aus der Anwesenheit eines Trägers vor der Synchronisation der Schleife resultieren, im wesentlichen nicht beeinflußt werden.

## Revendications

1. Récepteur à modulation d'amplitude (AM) comportant une boucle à phase asservie (O, M3, A4, R₁, R₂) comprenant un moyen oscillant (O) pour démoduler de façon synchronisée un signal d'entrée afin de produire des signaux de sortie en phase (I) et en quadrature de phase (Q), et un moyen (M3) pour mélanger les signaux de sortie afin de produire le signal d'erreur de la boucle à phase asservie, caractérisé par un circuit d'intégration (A4, R₁, R₂) dans la boucle à phase asservie, réagissant au signal d'erreur pour commander le moyen oscillant (O) de la boucle de manière à maintenir une synchronisation pendant les arrêts de modulation.

2. Récepteur selon la revendication 1, dans lequel le signal d'entrée est un signal de haute-fréquence (RF) et le récepteur est un récepteur à conversion directe.

3. Récepteur selon la revendication 1 ou la revendication 2, comportant un moyen formant filtre passe-haut (N9, N11) pour éliminer des signaux de sortie en phase et en quadrature de phase les composantes résultant de la présence de la porteuse quand la boucle à phase asservie est voisine de la synchronisation.

4. Récepteur selon l'une quelconque des revendications précédentes, comprenant des moyens (N8, N10) pour modifier la phase des composantes basse fréquence présentes dans le signal de sortie en quadrature de phase par rapport aux composantes basse-fréquence présentes dans le signal de sortie en phase de manière à provoquer la production d'un signal d'erreur en réponse aux composantes de porteuse des signaux de sortie en phase et en quadrature de phase pendant que la boucle n'est pas synchronisée pour faciliter la synchronisation de la boucle.

5. Récepteur selon la revendication 4, dans lequel le moyen (N8, N10) faisant varier la phase est conçu de manière que les phases des signaux ayant les fréquences de la bande de base ne soient pas notablement influencées.

6. Récepteur selon l'une quelconque des revendications précédentes, comprenant un moyen (A1, 12) de commande automatique de gain dans les circuits empruntés par les signaux de sortie en phase et en quadrature de phase.

7. Récepteur selon la revendication 6, dans lequel le moyen de commande automatique de gain comprend un amplificateur (A1, A2) à gain variable dans chacun desdits circuits, les amplificateurs étant tous deux commandés en réponse au niveau du signal de sortie en phase (I).

8. Récepteur selon la revendication 6 ou la revendication 7, dans lequel la largeur de bande de la boucle du moyen (A1, A2) de commande automatique de gain est sensiblement inférieure à celle de la boucle à phase asservie (O, M3, A4, R₁, R₂).

9. Récepteur selon l'une quelconque des revendications 6 à 8, dans lequel le moyen (A1, A2) de commande automatique de gain est relativement insensible aux fréquences basses de sorte qu'il n'est pas influencé notablement par la présence des composantes résultant de la présence d'une porteuse avant un synchronisation de la boucle.
